# EUROPÄISCHE PATENTSCHRIFT

(11) **EP 2 035 260 B1**
(45) Veröffentlichungstag und Bekanntmachung des Hinweises auf die Patenterteilung: **11.07.2012**
(21) Anmeldenummer: 07729643.2
(22) Anmeldetag: 30.05.2007
(51) Int. Cl.: B60R 16/023, F16B 2/20, F16B 5/06, F16B 13/08, F16B 21/08, H05K 5/02

(54) **BEFESTIGUNGSELEMENT ZUR BEFESTIGUNG UND/ODER VORFIXIERUNG EINES BAUTEILS AN EINER MIT EINER ÖFFNUNG VERSEHENEN HALTERUNG, SOWIE BAUTEIL MIT BEFESTIGUNGSELEMENT**
FASTENING ELEMENT FOR FASTENING AND/OR TEMPORARILY FASTENING A COMPONENT TO A MOUNT WHICH IS PROVIDED WITH AN OPENING, AND A COMPONENT WITH A FASTENING ELEMENT
ÉLEMENT DE FIXATION POUR FIXER ET/OU PREFIXER UN COMPOSANT A UN SUPPORT MUNI D'UNE OUVERTURE AINSI QUE COMPOSANT MUNI D'UN ELEMENT DE FIXATION

(30) Priorität: 16.06.2006 DE 102006027751
(43) Veröffentlichungstag der Anmeldung: 18.03.2009
(73) Patentinhaber: Robert Bosch GmbH, 70442 Stuttgart (DE)
(72) Erfinder: WOERNLE, Wolfgang, 72149 Neustetten (DE); HERRMANN, Alexander, 72764 Reutlingen (DE); LUDWIG, Matthias, 72116 Moessingen (DE); BRUNA FERNANDEZ, Antonio, 72766 Reutlingen (DE)
(86) Internationale Anmeldenummer: PCT/EP2007/055226
(87) Internationale Veröffentlichungsnummer: WO 2007/144260

(56) Entgegenhaltungen:
- EP-A1- 1 291 534
- EP-A1- 1 387 091
- DE-A1-102004 035 805
- DE-A1-102005 018 833
- NL-C2- 1 027 731
- US-A1- 2005 244 250

## Beschreibung

Die Erfindung betrifft ein Befestigungselement zur Befestigung und/oder Vorfixierung eines Bauteils, insbesondere Elektronikbauteils, an einer mit einer Öffnung versehenen Halterung gemäß dem Oberbegriff des Anspruchs 1, und insbesondere zur Fixierung und/oder Vorfixierung eines Sensors oder Elektroniksteuergeräts an einem mit einer Öffnung versehenen Karosserieteil eines Kraftfahrzeugs, sowie ein Bauteil, insbesondere Elektronikbauteil, das zur Befestigung an einer mit einer Öffnung versehenen Halterung mit mindestens einem solchen Befestigungselement versehen ist.

### Stand der Technik

In der Vergangenheit wurden Elektronikbauteile, wie zum Beispiel Beschleunigungssensoren oder Elektroniksteuergeräte von Kraftfahrzeugen, die in einer vorgegebenen Lage oder Ausrichtung montiert werden mussten, zumeist mit Hilfe von zwei oder mehr Schrauben befestigt, die durch parallele, in ein Kunststoffgehäuse der Bauteile eingesetzte zylindrische Stahlhülsen hindurch in entsprechende Schraubenbohrungen eines zur Befestigung dienenden Halteblechs der Fahrzeugkarosserie eingeschraubt wurden. Bei diesen Bauteilen war das Gehäuse darüber hinaus häufig mit einem angeformten Kunststoffstift versehen, der zwecks Vorfixierung der Bauteile während der Montage in eine entsprechende zusätzliche Bohrung des Halteblechs eingeführt wurde, jedoch nur eine untergeordnete Funktion für die Dauer der Montage erfüllte.

Da aus Kostengründen zunehmend eine Befestigung derartiger Elektronikbauteile mittels einer einzigen Schraube gefordert wurde, wurden die Gehäuse der Elektronikbauteile dann an Stelle des nur zur Vorfixierung dienenden Kunststoffstifts mit einem oder zwei robusteren angeformten Kunststoffbolzen versehen, die vor dem Eindrehen der Schraube in die Schraubenbohrung in komplementäre Bohrungen der Halterung eingeführt wurden, um für eine definierte Positionierung des Bauteils in Bezug zur Halterung zu sorgen und ein Verdrehen des Bauteils während des Festziehens der Schraube zu verhindern.

In letzter Zeit wird zudem gefordert, die Elektronikbauteile vor dem Eindrehen der Schraube mit der Halterung zu verrasten, um eine einhändige Montage der Bauteile zu ermöglichen. Für diese Rastfunktion bietet sich an, die am Gehäuse angeformten, bisher nur als Positionierhilfe und Verdrehsicherung dienenden Kunststoffbolzen durch Befestigungsclips zu ersetzen, wie sie auf dem Kraftfahrzeugsektor bereits zu anderen Zwecken verwendet werden, zum Beispiel zur Befestigung von Türinnenverkleidungen oder dergleichen Bauteilen. Diese Befestigungsclips weisen üblicherweise zwei im Abstand voneinander angeordnete, über das Bauteil überstehende parallele biegsame Raststifte auf, deren freie Enden auf ihren voneinander abgewandten Außenseiten mit überstehenden Rastnasen versehen sind und beim Hindurchtritt der Rastnasen durch eine entsprechend bemessene Öffnung zusammengedrückt werden, bevor die Rastnasen nach ihrem Hindurchtritt durch die Öffnung einen Rand derselben an diametral gegenüberliegenden Stellen hintergreifen.

Eine Verwendung derartiger Befestigungsclips hat jedoch Nachteile. Erstens weisen derartige Befestigungsclips eine relativ geringe Fallfesfigkeit auf, so dass beim Transport und bei der Montage nicht selten einer oder beide Raststifte infolge von Stößen oder Schlägen abbrechen, wodurch entweder das gesamte Elektronikbauteil unbrauchbar oder zumindest seine Montage erheblich erschwert wird. Zweitens weisen derartige Befestigungsclips infolge der elastischen Biegsamkeit und der kleineren Querschnittsabmessungen der Raststifte im Vergleich zu starren Bolzen eine geringere Positioniergenauigkeit auf. Nicht zuletzt kann auch ihre Funktion als Verdrehsicherung beeinträchtigt werden, wenn beim Eindrehen der Schraube ein übermäßig hohes Drehmoment auf das Bauteil ausgeübt wird, das infolge der kleineren Querschnittsabmessungen der Raststifte im Vergleich zu starren Bolzen zum Abscheren von einem oder sogar beiden Raststiften eines Befestigungsclips führen kann.

Aus der gattungsbildenden EP 1291534 Al ist ein Befestigungselement mit einem domartigen Vorsprung bekannt, in dessen zwei sich gegenüberliegenden seitlichen Aussparungen Raststifte angeordnet sind. Durch ein Hindurchführen des Befestigungselementes durch eine Öffnung in einem Befestigungsblech werden die Rastnasen nach innen durchgedrückt und hintergreifen dann in der Endstellung des Befestigungselementes die Öffnung des Befestigungsbleches. Dabei ist das Befestigungselement als Kunststoffspritzgussteil ausgeführt.

Ferner beschreibt die NL 1027731 C Ausführungen von Befestigungselementen, die durch Raststifte in Befestigungsöffnungen eingeclipst werden. Dabei sind mehre Raststifte in der Art vorgesehen, dass das Befestigungselement als Verbindungselement dient, indem beidseitig in zwei Befestigungsbohrungen eingeclipst werden kann.

Ausgehend hiervon liegt der Erfindung die Aufgabe zugrunde, ein Befestigungselement der eingangs genannten Art dahingehend zu verbessern, dass es eine größere Fall- und Scherfestigkeit aufweist und für eine größere Positioniergenauigkeit bei der Montage sorgt.

### Offenbarung der Erfindung

Diese Aufgabe wird erfindungsgemäß dadurch gelöst, dass die Raststifte in einer oder vorzugsweise zwei Aussparungen eines insbesondere über das Elektronikbauteil überstehenden Vorsprungs angeordnet sind, der sich vorzugsweise beiderseits der Raststifte jeweils bis zu deren entgegengesetzte Außenseiten erstreckt, so dass nur die Rastnasen der Raststifte über einen äußeren Umriss des Vorsprungs überstehen, während der übrige Teil der Raststifte weitgehend vor Stößen und Schlägen geschützt innerhalb der Aussparung oder Aussparungen untergebracht ist.

Der starre Vorsprung hat somit zum einen eine Schutzfunktion, indem er nicht nur eine Beschädigung der Raststifte infolge von Schlägen oder Stößen beim Transport, sondern auch ihr Abscheren infolge der Einwirkung eines übergroßen Drehmoments zwischen dem Elektronikbauteil und der Halterung während des Festziehens der Schraube verhindert, und kann darüber hinaus auch eine Positionierfunktion übernehmen, wenn er gemäß einer weiteren bevorzugten Ausgestaltung der Erfindung beiderseits der Raststifte einen an den Öffnungsquerschnitt der Öffnung angepassten Querschnitt aufweist.

Vorzugsweise besitzt die Öffnung die Form eines kurzen Langlochs mit zwei halbkreisförmigen Begrenzungswandabschnitten, deren Krümmungs-radius dem Krümmungsradius zweier gerundeter Umfangsflächen von beiderseits der Raststifte angeordneten Teilen des Vorsprungs entspricht, sowie zwei zwischen den gerundeten Begrenzungswandabschnitten angeordneten geradlinigen Begrenzungswandabschnitten, die den Rastnasen der Raststifte gegenüberliegen. Alternativ kann die Öffnung jedoch auch andere Formen aufweisen, zum Beispiel eine ovale Form.

Erfindungsgemäβ ist vorgesben dass die Raststifte derart in den Aussparungen angeordnet sind, dass nur die Rastnasen über einen äußeren Umriss des Vorsprungs überstehen, so dass die Rastnasen bei einem versehentlichen Herabfallen des Bauteils nicht abbrechen können.

Um beim Einführen des Befestigungselements in die Öffnung der Halterung ein Überbiegen der Raststifte zu verhindern, sind die einander zugewandten Innenseiten der Raststifte zweckmäßig in einem Abstand von benachbarten Begrenzungsflächen der Aussparungen angeordnet, der es gestattet, die Raststifte ausreichend weit in die Aussparungen hinein zu verbiegen, so dass ihre Rastnasen durch die Öffnung gleiten können, jedoch ein stärkeres Umbiegen der Raststifte verhindern. Dazu sind vorzugsweise die beiderseits der Raststifte angeordnete Teile des Vorsprungs durch einen zwischen den Raststiften angeordneten Steg verbunden, dessen entgegengesetzte Außenseiten als Anschlag für die benachbarten Innenseiten der Raststifte dienen und deren Überbiegen verhindern. Darüber hinaus vergrößert der Steg die Stabilität des Vorsprungs und damit auch die Fallfestigkeit des Befestigungselements.

Um das Einführen des Vorsprungs in die Öffnung zu erleichtern, weist der Vorsprung zweckmäßig ein verjüngtes freies Ende auf, wobei zweckmäßig die beiderseits der Raststifte angeordneten Teile an ihren freien Enden von kugelsegmentförmigen oder pyramidenartigen Flächen begrenzt werden.

zudem erstreckt sich erfindungsgemäβ jede der beiden Aussparungen über die gesamte Länge des Vorsprungs, wobei ihre Querschnittsform zweckmäßig an die Querschnittsform des in der Aussparung angeordneten Raststifts angepasst ist, jedoch etwas größere Abmessungen aufweist, so dass sich der Raststift innerhalb der Aussparung ungehindert so weit verbiegen kann, dass ein Hindurchtritt der Rastnase durch die Öffnung der Halterung möglich ist.

Um die Herstellung eines Formwerkzeugs zum Formen des Gehäuses des elektronischen Bauteils aus einem Kunststoffmaterial zu erleichtern, ist der Vorsprung zweckmäßig spiegelsymmetrisch zu einer zu den Außen- bzw. Innenseiten der Raststifte parallelen Ebene und/oder spiegelsymmetrisch zu einer dazu senkrechten Mittelebene der beiden Raststifte. Das Kunststoffmaterial des Gehäuses ist bevorzugt ein faserverstärktes Kunststoffmaterial und enthält zweckmäßig mindestens 20 % und vorzugsweise 30 % Gasfasern, um so die Bruch- und Scherfestigkeit des Vorsprungs und der Raststifte weiter zu verbessern.

### Kurze Beschreibung der Zeichnungen

Die Erfindung wird nachfolgend in einem Ausführungsbeispiel anhand der zugehörigen Zeichnungen näher erläutert. Es zeigen:
- Fig. 1: eine perspektivische Ansicht von einem Kunststoffgehäuse eines Beschleunigungssensors eines Kraftfahrzeugs mit einem erfindungsgemäßen Befestigungselement sowie von einem zur Montage des Gehäuses dienenden Halteblech;
- Fig. 2: eine Seitenansicht des Befestigungselements in Richtung des Pfeils A in Fig. 1;
- Fig. 3: eine Seitenansicht des Befestigungselements in Richtung des Pfeils B in Fig. 1;
- Fig. 4: eine Stirnseitenansicht des Befestigungselements;
- Fig. 5: eine Schnittansicht des Befestigungselements entlang der Linie V-V in Fig. 2;
- Fig. 6: eine Ansicht entsprechend Fig. 5, jedoch beim Hindurchtritt des Befestigungselements durch eine Öffnung des Haltblechs;
- Fig. 7: eine Ansicht entsprechend Fig. 5, jedoch nach dem Hindurchtritt des Befestigungselements durch die Öffnung des Haltblechs.

### Ausführungsform der Erfindung

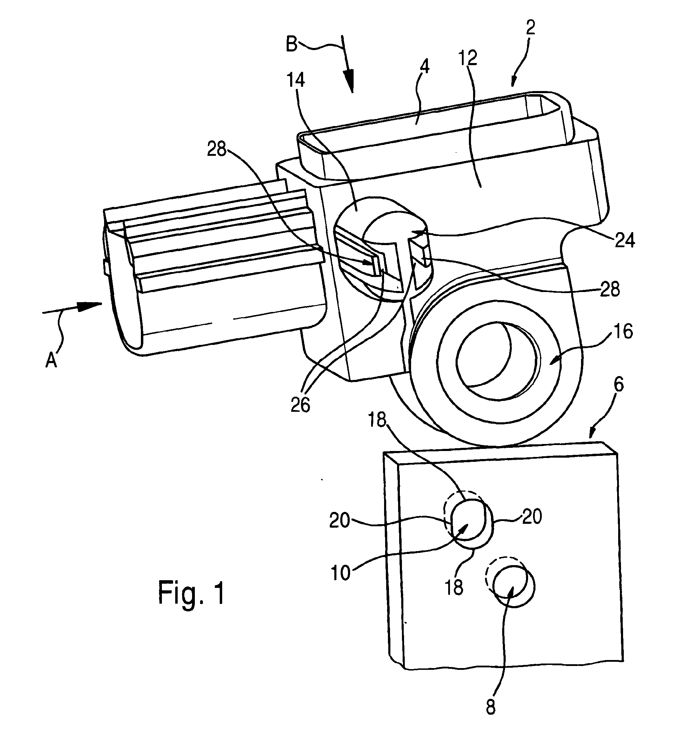

Das in Fig. 1 dargestellte Kunststoffgehäuse 2 dient zur Aufnahme eines Beschleunigungssensors (nicht dargestellt) eines Kraftfahrzeugs, der durch eine obere Einbauöffnung 4 in das Gehäuse 2 eingesetzt wird. Nach dem Verschließen der Einbauöffnung 4 mittels eines Deckels (nicht dargestellt), wird das Gehäuse 2 mit dem Beschleunigungssensor in einer vorgegebenen Ausrichtung in Bezug zum Kraftfahrzeug an einem Halteblech 6 montiert, das einen Teil einer Karosserie des Kraftfahrzeugs bildet und mit zwei ausgestanzten Durchtrittsöffnungen 8, 10 versehen ist, von denen die Öffnung 8 einen kreisförmigen Öffnungsquerschnitt und die Öffnung 10 einen nicht-kreisförmigen Öffnungsquerschnitt aufweist.

Zur Montage am Halteblech 6 weist das Gehäuse 2 ein über eine Breitseitenfläche 12 überstehendes Befestigungselement 14 auf, das in die Öffnung 10 des Halteblechs 6 eingeclipst wird, sowie eine bei der Herstellung des Gehäuses 2 durch Spritzgießen aus einem mit 30 % Glasfaser verstärkten Kunststoff in das Gehäuse 2 eingeformte und dadurch einstückig mit dem Gehäuse 2 verbundene zylindrische Stahlhülse 16, die nach dem Einclipsen des Befestigungselements 14 in die Öffnung 10 mit der Öffnung 8 des Halteblechs 6 fluchtet, so dass eine selbstschneidende Befestigungsschraube (nicht dargestellt) mit einem zylindrischen Schaftteil mit einer Hand durch die Stahlhülse 16 hindurch in die Öffnung 8 eingeschraubt werden kann, das heißt, ohne dass das mittels des Befestigungselements 14 in Bezug zum Halteblech 6 fixierte Gehäuse 2 des Beschleunigungssensors mit der anderen Hand festgehalten werden muss.

Um dies zu ermöglichen, entspricht zum einen der Mittenabstand der beiden Öffnungen 8, 10 dem Abstand zwischen einer Mittelachse der Stahlhülse 16 und einer dazu parallelen Mittelachse des Befestigungselements 14. Zum anderen weist das Befestigungselement 14 einen an den Öffnungsquerschnitt der Öffnung 10 angepassten Umriss auf, so dass es nur in einer vorbestimmten Ausrichtung in die Öffnung 10 eingeführt werden kann, in welcher Ausrichtung die Stahlhülse 16 genau vor der Öffnung 8 des Halteblechs 6 zu liegen kommt.

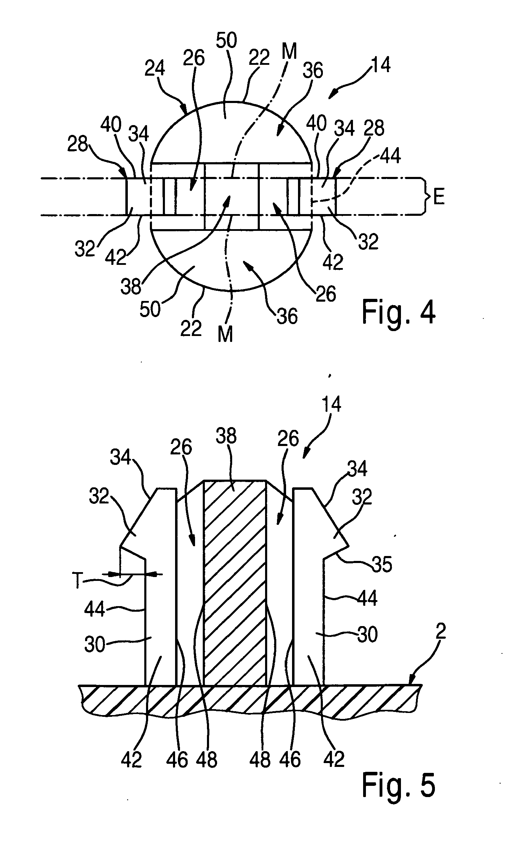

Bei der in der Zeichnung dargestellten Ausführungsform wird die Öffnung 10 von einem kurzen Langloch gebildet, bei dem zwei halbzylindrische Begrenzungswandabschnitte 18 durch zwei gegenüberliegende kurze ebene Begrenzungswandabschnitte 20 verbunden sind. Das Befestigungselement 14 weist einen dazu komplementären Umriss auf, wie am besten in Fig. 4 dargestellt, wobei dieser Umriss zwei entgegengesetzte teilzylindrische Umfangsflächenabschnitte 22 umfasst, die zu den Begrenzungswandabschnitten 18 der Öffnung 10 kongruent sind, sich jedoch über einen etwas kleineren Bogenwinkel als 180 Grad erstrecken.

Alternativ dazu könnten jedoch auch zwei zum Einclipsen in Öffnungen des Halteblechs dienende Befestigungselemente (nicht dargestellt) im Abstand voneinander und von der Stahlhülse 16 am Gehäuse 2 des Beschleunigungssensors vorgesehen werden, in welchem Fall die beiden Befestigungselemente und die zugehörigen Öffnungen auch mit einem kreisförmigen Umriss bzw. Öffnungsquerschnitt versehen werden könnten.

Das in der Zeichnung dargestellte Befestigungselement 14 besteht im Wesentlichen aus einem über die Breitseitenfläche 12 überstehend am Gehäuse 2 angeformten Vorsprung 24 und zwei im Abstand voneinander in seitlichen Aussparungen 26 des Vorsprungs 24 angeordneten, ebenfalls über das Gehäuse 2 überstehend an diesem angeformten elastisch biegsamen Raststiften 28.

Während die Raststifte 28 zum Einclipsen in die Öffnung 10 und dadurch zum Verrasten des Gehäuses 2 am Halteblech 6 dienen, dient der Vorsprung 24 erstens vor der Montage als Schutz für die Raststifte 28, die vor Stößen und Schlägen gut geschützt in den Aussparungen 26 des Vorsprungs 24 untergebracht sind, zweitens als Positionierhilfe bei der Montage der Gehäuses 2, indem er die Stahlhülse 16, wie oben beschrieben, genau vor der Öffnung 8 des Halteblechs 6 positioniert, und drittens als Verdrehsicherung, indem er ein Verdrehen des Gehäuses 2 in Bezug zum Halteblech 6 verhindert, wenn beim Einschrauben der Befestigungsschraube ein Drehmoment in Bezug zum Halteblech 6 auf das Gehäuse 2 aufgebracht wird.

Die beiden Raststifte 28 weisen jeweils einen Schaftteil 30 mit einem quadratischen oder rechteckigen Querschnitt und einem als Rasthaken ausgebildeten freien Ende aus, das von einer über die Außenseite des Schaftteils 30 jedes Raststifts 28 überstehenden Rastnase 32 gebildet wird. Nach ihrem Hindurchtritt durch die Öffnung 10 hintergreifen die Rastnasen 32 der beiden Raststifte 28 deren vom Gehäuse 2 abgewandten Rand im Bereich der beiden Begrenzungswandabschnitte 20 in Fig. 1. Um das Einführen der Raststifte 28 in die Öffnung 10 zu erleichtern, sind die Rastnasen 32 in bekannter Weise mit Einführschrägen 34 versehen. Auf ihrer dem Gehäuse 2 zugewandten Rückseite sind die Rastnasen bei 35 leicht angeschrägt.

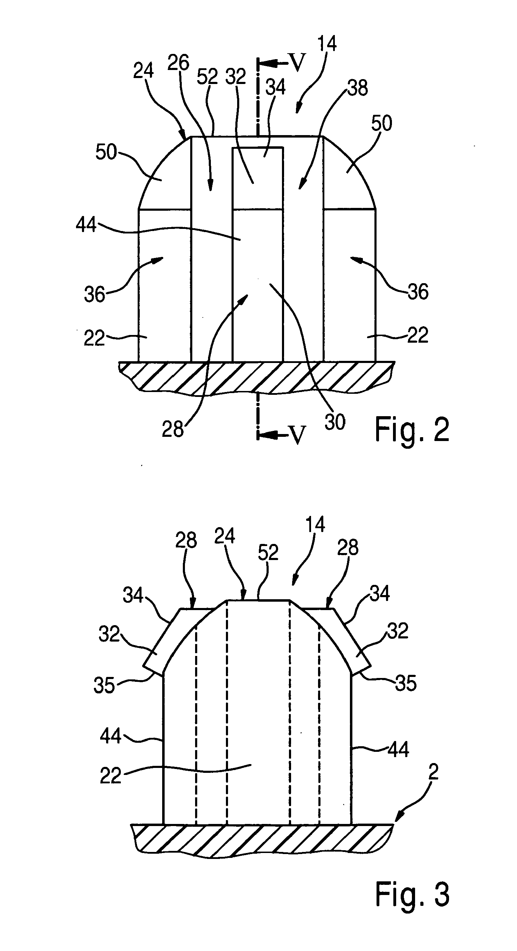

Wie am besten in Fig. 2 und 4 dargestellt, besteht der Vorsprung 24 aus zwei im Abstand beiderseits der Raststifte 28 angeordneten Teilen 36 mit kreissegmentförmigem Querschnitt, die durch einen in der Mitte zwischen den Raststiften 28 angeordneten Steg 38 mit rechteckigem Querschnitt einstückig miteinander verbunden sind. Die beiden Teile 36 und der Steg 38 begrenzen zusammen die beiden Aussparungen 26, die nach entgegengesetzten Seiten hin offen sind, sich über die gesamte Länge des Vorsprungs 24 erstrecken und einen rechteckigen Querschnitt aufweisen, dessen Querschnittsabmessungen größer als die Querschnittsabmessungen der Raststifte 28 sind.

Wie bereits angegeben, ist der Vorsprung 24 im Bereich der Teile 36 mit den teilzylindrischen Umfangsflächenabschnitten 22 versehen, deren Mittelachsen M in einem der Breite der Begrenzungswandteile 20 der Öffnung 10 entsprechenden Abstand voneinander in zwei von benachbarten ebenen Seitenflächen 40, 42 der beiden Raststifte 28 aufgespannten parallelen Ebenen E liegen, so dass die ebenen Außenseiten 44 der Schaftteile 30 der Raststifte 28 nach dem Einführen des Befestigungselements 14 in die Öffnung 10 flächig gegen deren Begrenzungswandabschnitte 20 anliegen, wenn die Rastnasen 32 den vom Gehäuse 2 abgewandten Rand der Öffnung 10 bzw. die vom Gehäuse 2 abgewandte Breitseitenfläche des Halteblechs 6 hintergreifen.

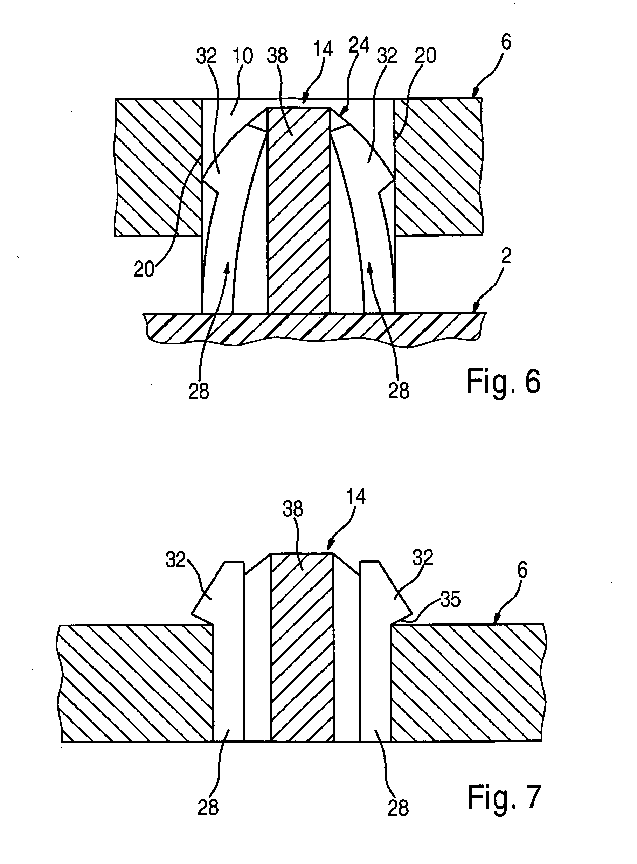

Der Abstand zwischen den Innenseiten 46 (Fig. 5) der Raststifte 28 und den benachbarten Begrenzungsflächen 48 des Stegs 38 entspricht in etwa der Tiefe T der Rastnasen 32, so dass die Innenseiten 46 der Raststifte 28 im Bereich ihrer freien Enden einen geringen Abstand von entgegengesetzten ebenen Begrenzungsflächen 48 des Stegs 38 aufweisen, wenn der Vorsprung 24 beim Einclipsen des Befestigungselements 14 in der Öffnung 10 durch diese hindurchtritt, wie in Fig. 6 dargestellt, wobei die Spitzen der Rastnasen 32 an den Begrenzungswandabschnitten 20 entlang gleiten. In dem Fall, dass der Vorsprung 24 während des Einführens in die Öffnung 10 in Bezug zu dieser verkantet wird, schlägt dann das freie Ende von demjenigen der Raststifte 28, der durch das Verkanten stärker gebogen wird, gegen die benachbarte Begrenzungsfläche 48 des Stegs 38 an, so dass sein Überbiegen verhindert wird.

Wie am besten in Fig. 4 dargestellt, ist das Befestigungselement 14 spiegelsymmetrisch zu einer durch die Mittelachsen M der Umfangsflächenabschnitte 22 verlaufenden Ebene sowie einer dazu senkrechten Ebene in der Mitte zwischen den beiden Mittelachsen M.

Um das Einführen des Vorsprungs 24 in die Öffnung 10 zu erleichtern, weist der Vorsprung 24 ein verjüngtes freies Ende auf, das von zwei kugelsegmentförmig gerundeten Stirnenden 50 der beiden Teile 36 und von einem ebenen Stirnende 52 des Stegs 38 gebildet wird.

## Patentansprüche

1. Befestigungselement zur Befestigung und/oder Vorfixierung eines Bauteils an einer mit einer Öffnung versehenen Halterung, mit zwei im Abstand voneinander angeordneten, biegsamen Raststiften, die jeweils in der Nähe ihrer freien Enden mit Rastnasen versehen sind, welche über entgegengesetzte Außenseiten der Raststifte überstehen und nach ihrem Hindurchtritt durch die Öffnung der Halterung einen Rand der Öffnung hintergreifen, wobei die beiden Rastsfifte (28) in einer Aussparung (26) eines Vorsprungs (24) derart angeordnet sind, dass nur die Rastnasen (28) über einen äußeren Umriss des Vorsprungs (24) überstehen, **dadurch gekennzeichnet, dass** sich die Aussparungen (26) über die gesamte Länge des Vorsprungs (24) erstrecken und der Vorsprung (24) und die Raststifte (28) aus faserverstärktem Kunststoffmaterial bestehen.

2. Befestigungselement nach Anspruch 1, **dadurch gekennzeichnet, dass** einander zugewandte Innenseiten (46) der Raststifte (28) in einem Abstand von benachbarten Begrenzungsflächen (48) der Aussparungen (26) angeordnet sind, der eine Tiefe (T) der Rastnasen (32) geringfügig übersteigt.

3. Befestigungselement nach einem der vorangehenden Ansprüche, **dadurch gekennzeichnet, dass** der Vorsprung (24) beiderseits der Raststifte (28) einen an den Öffnungsquerschnitt der Öffnung (10) angepassten Querschnitt aufweist.

4. Befestigungselement nach einem der vorangehenden Ansprüche, **dadurch gekennzeichnet, dass** beiderseits der Raststifte (28) angeordnete Teile (36) des Vorsprungs (24) von gerundeten Umfangsflächen (22) begrenzt werden.

5. Befestigungselement nach einem der vorangehenden Ansprüche, **dadurch gekennzeichnet, dass** beiderseits der Raststifte (28) angeordnete Teile (36) des Vorsprungs (24) durch einen Steg (38) verbunden sind.

6. Befestigungselement nach einem der vorangehenden Ansprüche, **dadurch gekennzeichnet, dass** der Vorsprung (24) ein verjüngtes freies Ende (50) aufweist.

7. Befestigungselement nach einem der vorangehenden Ansprüche, **dadurch gekennzeichnet, dass** der Vorsprung (24) spiegelsymmetrisch zu einer zu Außen- und/oder Innenseiten (44, 46) der Raststifte (26) parallelen Ebene und/oder zu einer Mittelebene der beiden Raststifte (28) ist.

8. Bauteil, insbesondere Elektronikbauteil, **gekennzeichnet durch** mindestens ein Befestigungselement (14) nach einem der vorangehenden Ansprüche.

9. Bauteil nach Anspruch 8, **dadurch gekennzeichnet, dass** das der Vorsprung (24) und die Raststifte (28) einstückig an einem Gehäuse (2) des Bauteils angeformt sind.

10. Bauteil nach einem der Ansprüche 8 oder 9, **gekennzeichnet durch** eine im Abstand vom Befestigungselement (14) in das Gehäuse (2) eingesetzte Zentrierhülse (16) für eine ebenfalls zur Befestigung an der Halterung (6) dienende Befestigungsschraube.

## Claims

1. Fastening element for fastening and/or pre-fixing a component to a mount provided with an opening, having two flexible latching pins which are arranged in a manner spaced apart from one another and are provided in each case in the vicinity of their free ends with latching lugs which protrude beyond opposing outer sides of the latching pins and, after passing through the opening in the mount, engage behind a rim of the opening, wherein the two latching pins (28) are arranged in a cutout (26) in a protrusion (24) such that only the latching lugs (28) protrude beyond an outer contour of the protrusion (24), **characterized in that** the cutouts (26) extend along the entire length of the protrusion (24) and the protrusion (24) and the latching pins (28) consist of fibre-reinforced plastics material.

2. Fastening element according to Claim 1, **characterized in that** mutually facing inner sides (46) of the latching pins (28) are arranged at a distance from adjacent boundary surfaces (48) of the cutouts (26), said distance slightly exceeding a depth (T) of the latching lugs (32).

3. Fastening element according to either of the preceding claims, **characterized in that** the protrusion (24) has, on both sides of the latching pins (28), a cross section adapted to the opening cross section of the opening (10).

4. Fastening element according to one of the preceding claims, **characterized in that** parts (36) of the protrusion (24) that are arranged on both sides of the latching pins (28) are bounded by rounded peripheral surfaces (22).

5. Fastening element according to one of the preceding claims, **characterized in that** parts (36) of the protrusion (24) that are arranged on both sides of the latching pins (28) are connected by a web (38).

6. Fastening element according to one of the preceding claims, **characterized in that** the protrusion (24) has a tapered free end (50).

7. Fastening element according to one of the preceding claims, **characterized in that** the protrusion (24) is mirror-symmetrical with respect to a plane parallel to outer and/or inner sides (44, 46) of the latching pins (28) and/or with respect to a central plane of the two latching pins (28).

8. Component, in particular electronic component, **characterized by** at least one fastening element (14) according to one of the preceding claims.

9. Component according to Claim 8, **characterized in that** the protrusion (24) and the latching pins (28) are integrally moulded on a housing (2) of the component.

10. Component according to either of Claims 8 and 9, **characterized by** a centring sleeve (16), inserted into the housing (2) at a distance from the fastening element (14), for a fastening screw that likewise serves for fastening to the mount (6).

## Revendications

1. Élément de fixation pour fixer et/ou préfixer un composant à un support muni d'une ouverture, comprenant deux broches d'encliquetage flexibles disposées à distance l'une de l'autre qui sont munies respectivement, à proximité de leurs extrémités libres, d'ergots d'encliquetage qui dépassent de côtés extérieurs opposés des broches d'encliquetage et qui viennent en prise par l'arrière avec un bord de l'ouverture après leur passage à travers l'ouverture du support, les deux broches d'encliquetage (28) étant disposées dans un évidement (26) d'une saillie (24) de telle sorte que seuls les ergots d'encliquetage (28) dépassent d'un pourtour extérieur de la saillie (24), **caractérisé en ce que** les évidements (26) s'étendent sur toute la longueur de la saillie (24), et la saillie (24) ainsi que les broches d'encliquetage (28) sont constituées de matière plastique renforcée par des fibres.

2. Élément de fixation selon la revendication 1, **caractérisé en ce que** des côtés intérieurs (46) se faisant face des broches d'encliquetage (28) sont disposés à une distance de surfaces de délimitation (48) adjacentes des évidements (26) qui excède légèrement une profondeur (T) des ergots d'encliquetage (32).

3. Élément de fixation selon l'une quelconque des revendications précédentes, **caractérisé en ce que** la saillie (24) présente de part et d'autre des broches d'encliquetage (28) une section transversale adaptée à la section transversale de l'ouverture (10).

4. Élément de fixation selon l'une quelconque des revendications précédentes, **caractérisé en ce que** des parties (36) de la saillie (24) disposées de part et d'autre des broches d'encliquetage (28) sont délimitées par des surfaces périphériques (22) arrondies.

5. Élément de fixation selon l'une quelconque des revendications précédentes, **caractérisé en ce que** des parties (36) de la saillie (24) disposées de part et d'autre des broches d'encliquetage (28) sont reliées par un élément jointif (38).

6. Élément de fixation selon l'une quelconque des revendications précédentes, **caractérisé en ce que** la saillie (24) comprend une extrémité libre (50) amincie.

7. Élément de fixation selon l'une quelconque des revendications précédentes, **caractérisé en ce que** la saillie (24) présente une symétrie miroir par rapport à un plan parallèle à des côtés extérieurs et/ou intérieurs (44, 46) des broches d'encliquetage (26) et/ou présente une symétrie miroir par rapport à un plan médian des deux broches d'encliquetage (28).

8. Composant, en particulier composant électronique, **caractérisé par** au moins un élément de fixation (14) selon l'une quelconque des revendications précédentes.

9. Composant selon la revendication 8, **caractérisé en ce que** la saillie (24) et les broches d'encliquetage (28) sont formées d'un seul tenant sur un boîtier (2) du composant.

10. Composant selon la revendication 8 ou 9, **caractérisé par** une douille de centrage (16), insérée dans le boîtier (2) à distance de l'élément de fixation (14), pour une vis de fixation servant également à la fixation au support (6).
